(19) Europäisches Patentamt / European Patent Office / Office européen des brevets

(11) **EP 3 982 167 A1**

(12) **EUROPEAN PATENT APPLICATION**

(43) Date of publication:
**13.04.2022  Bulletin 2022/15**

(21) Application number: **20200329.9**

(22) Date of filing: **06.10.2020**

(51) International Patent Classification (IPC):
**G02B 5/02** (2006.01)   **G02B 27/09** (2006.01)
**H01S 5/183** (2006.01)   **G02B 19/00** (2006.01)
**H01L 33/58** (2010.01)

(52) Cooperative Patent Classification (CPC):
**G02B 5/0215; G02B 5/0278; G02B 19/0052; G02B 27/0927; G02B 27/095; H01S 5/18388;** H01S 5/04257; H01S 5/18305

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **TRUMPF Photonic Components GmbH 89081 Ulm (DE)**

(72) Inventor: **Gronenborn, Stephan 89081 Ulm (DE)**

(74) Representative: **Trumpf Patentabteilung Trumpf GmbH & Co KG TH550 Patente und Lizenzen Johann-Maus-Straße 2 71254 Ditzingen (DE)**

(54) **DIFFUSOR LENS, LIGHT SOURCE, METHOD OF FABRICATING A LIGHT SOURCE AND METHOD OF ILLUMINATING A SCENE**

(57)    The present invention describes a diffusor lens (1), comprising a first annular lens segment (12) and a second annular lens segment (14), the first and second lens segment (12, 14) being concentric, wherein the first and second lens segment (12, 14) adjoin at an interface (10), and wherein a first surface profile (22) of the first lens segment (12) and a second surface profile (24) of the second lens segment (14) have a slope with opposite sign in a cross-section along a plane including an optical axis of the diffusor lens (1). The present invention further describes a light source (50) comprising a VCSEL (70) and such a diffusor lens (1), a method of fabricating such a light source (50) and a method of illuminating a scene.

Fig. 7

**Description**

FIELD OF THE INVENTION

The present invention relates to a diffusor lens. The present invention further relates to a light source comprising a Vertical Cavity Surface Emitting Laser (VCSEL) and such a diffusor lens for diffusing the light emitted by the VCSEL. The present invention still further relates to a method of fabricating such a light source. The present invention still further relates to a method of illuminating a scene, in particular for sensing applications.

BACKGROUND OF THE INVENTION

VCSELs, in particular VCSEL arrays with engineered diffusors to create a rectangular beam profile in the field of view (FOV) of a camera are nowadays commonly used as illumination sources for 2D and 3D cameras. Extensive research is done on how to integrate the diffusors in the VCSEL chip as this integration typically leads to several problems which need to be overcome.

To achieve a good homogeneity of the preferred rectangular beam profile in the FOV of the camera, the diffusors need to be small. The diffusors may, for example, be an array of diffusor lenses. The small size of these diffusor lenses however results in diffraction losses as the lens array is typically illuminated homogenously, which leads to several incoming beams not ideally entering the center of each lens. These diffraction losses lead to inhomogeneity in the desired beam profile and reduce the quality of the sensing applications.

One possibility to overcome these problems is to use larger lenses. Using one or more larger lenses may avoid the discussed diffraction losses, but large apertures of the lenses automatically lead to a large height difference of the lenses along the optical axis, i.e., large lens sag. Large lenses with such a large height difference in their surface profile are difficult to integrate into a semiconductor chip with fabrication techniques such as grayscale lithography.

Fresnel lenses allow the construction of lenses with large aperture and reduce the lens sag compared to a conventional lens by dividing the lens into a set of concentric annular sections. The height difference is thus efficiently reduced compared to an equivalent standard lens. A problem that arises for Fresnel lenses is however that the design of a Fresnel lens is typically achieved by dividing the continuous surface of a standard lens into a set of curved surfaces, with stepwise discontinuities between them. These discontinuities cause losses and inhomogeneities in the desired beam profile.

Thus, there remains a need for an improved diffusor lens, in particular for illumination sources for 2D and 3D cameras.

SUMMARY OF THE INVENTION

It is an object of the present invention to provide an improved diffusor lens for diffusing incoming light such that a homogenous rectangular profile in a target area is achieved. This created homogenous beam profile may match, e.g., to the field of view of a camera and thus allows reliable sensing applications, such as time-of-flight (TOF) measurements.

It is a further object of the present invention to provide a light source with such an improved diffusor lens.

It is a further object of the present invention to provide a fabrication method of such a light source with an improved diffusor lens.

It is a further object of the present invention to provide a method of illuminating a scene.

The invention is described in the independent claims. Preferred embodiments are described in the dependent claims or are described in the subsequent portions of the description.

According to a first aspect of the present invention, a diffusor lens is provided that comprises a first annular lens segment and a second annular lens segment. The first and second lens segments are concentric with respect to each other. Further, the first and second lens segments adjoin at an interface. A first surface profile of the first lens segment and a second surface profile of the second lens segment have a slope with opposite sign in a cross-section along a plane including an optical axis of the diffusor lens.

The present invention is based on the idea to provide a flat diffusor lens with reduced lens sag, which may be preferably used in an array of VCSELs to transform incoming light to homogenously illuminate a scene, such as a field of view of a camera. For this purpose, the diffusor lens comprises at least two annular lens segments, wherein the first lens segment is concentrically arranged with respect to the second lens segment. This means that the first lens segment and the second lens segment share the same center, i.e., the center of the diffusor lens.

The expression "annular" means that the first lens segment and the second lens segment are ring-shaped. The shape of the ring may preferably be circular, but may also comprise other shapes being formed like a ring, such as an elliptical shape.

It shall be noted that the expression "first and second lens segment" shall not be understood as two independent lenses or lens parts, but rather as sections of one single diffusor lens. This also applies for the expressions of "a first surface profile" and "a second surface profile". These profiles together form a common profile which describes at least a part of the surface of the diffusor lens according to the present invention.

The concept of a lens divided into two or more sections or elements is already known from Fresnel lenses. An ideal Fresnel lens comprises an infinite number of such lens segments with curved surfaces and with stepwise discontinuities between them. At these stepwise discontinuities, the surface of a Fresnel lens is oriented parallel to the optical axis of the Fresnel lens. Hence, a standard Fresnel lens comprises (at least) two lens segments which adjoin at an interface, wherein one of these lens segments has a curved surface and the other lens segment is oriented parallel to the optical axis of the Fresnel lens, i.e., as a height step oriented along the optical axis.

B. Kim et al.: "Elimination of flux loss by optimizing the groove angle in modified Fresnel lens to increase illuminance uniformity, color uniformity, and flux efficiency", Optics Express, 17 (20), pp. 17916-17927 (2009) addresses the problem that Fresnel lenses can usually cause a loss of flux efficiency and non-uniform distribution of illuminance due to secondary refraction by the surface discontinuities, especially along the groove facet, i.e., along the height step. A modified Fresnel lens is disclosed for which the groove angle is optimized to maximize the uniformity in illumination.

In difference to said modified lens of B. Kim et al. and in difference to a standard Fresnel lens, the diffusor lens according to the present invention comprises two neighboring lens segments whose surface profiles have a slope with opposite sign. This means, for example, that two adjacent lens segments are alternately convexly and concavely curved. Compared to a standard Fresnel lens approach, the surface profile is continuous and does not have a problematic height step causing optical losses and inhomogeneities. In difference to the modified lens of B. Kim et al., the diffusor lens according to the present invention provides an improved uniformity of illuminance in the far field.

The benefit of a low height difference similar to a Fresnel lens, but without the problematic discontinuities of a Fresnel lens is surprisingly possible with the nature of the diffusor lens according to the invention, as two lenses with same aperture and same lens function except that the sign of the slope is reversed, have the same diffused beam profile.

The diffusor lens according to the present invention may be a single optical element, which may be one piece or monolithic, and which combines the capabilities to transform light emitted by any kind of light emitting elements into a homogeneous diffused beam profile in a target area. This measure provides simple, not bulky and low cost optics. Preferably, the single one-piece optical element may be integrated on a VCSEL array chip, but may also be arranged in a distance from the VCSEL array.

It shall be understood that the expression "diffusor lens" means that this lens is configured to diffuse light in one or more directions parallel to or inclined with respect to the optical axis of the diffusor lens.

Preferred embodiments of the diffusor lens will be described hereinafter. Preferred embodiments are not only those indicated in the dependent claims, but also those indicated in the entire disclosure herein.

In one embodiment, the slopes of the first surface profile of the first lens segment and the second surface profile of the second lens segment may be described by a same slope function but with opposite sign. As known in the art, the slope of a function is the first derivative function of said function. According to the present embodiment, said first derivative function (slope function) which describes the slopes of the first surface profile and the second surface profile is the same but with opposite sign. In other words, the slopes of the surfaces of the first lens segment and the second lens segment are described by the same function except that the sign of the slope is reversed. This means that the slope of the first surface profile is, e.g., a positive slope while the slope of the second surface profile is a negative slope. When the surfaces of the first and second lens segments are spherical for example, this also means that the curvatures of these surfaces have the same absolute value, but a different sign. The same concept applies if the surfaces are aspherical, wherein an aspherical surface may be a conical surface or any other non-spherical surface. Hence, the first and the second lens segments are adapted to transform incoming beams such that the same diffused beam profile is generated.

The function which describes the slopes of the first surface profile and the second surface profile may, e.g., be proportional to $r^n$ with r being a radius of the diffusor lens and n $\geq$0. Hence, the slope function (first derivate function) may be proportional to a constant for n=0. This is, e.g., the case if the first surface profile and the second surface profile both have the shape of a linear function in cross-section along a plane including the optical axis, as it is the case, for example, for a conical surface profile. For n > 0, the slope function may be a polynomial function. The slope is not infinite. When the first and second surfaces are curved, it is also possible to describe the first surface profile and the second surface profile by their curvature function, which is the second derivative function of the surface profiles. In this case, the curvatures of the first and second surface profiles may be the same for the first and second surface profiles, but having a different sign with respect to each other, for example one is convexly curved, and the other is concavely curved.

The transition from the first lens segment to the second lens segment at the interface may be continuous and not continuously differentiable. Compared to a standard Fresnel lens approach, the surface profile of the diffusor lens according to the invention does not have a problematic high step causing optical losses and inhomogeneities. As the first surface profile of the first lens segment and the second surface profile of the second lens segment have a slope or curvature with opposite sign, the crossover or transition from the first lens segment to the second lens segment at the interface of those is not continuously differentiable in this embodiment.

In an embodiment, the first surface profile and the second surface profile may be aspherical, in particular may have the shape of a conic section. The conical constant and/or the aspherical constants may be optimized to achieve a good homogeneity of the beam profile in the far field. In this embodiment, the diffusing properties of the diffusor lens are conferred by at least two adjacent aspherical sections with an opposite sign of slope, in particular one convexly curved surface and one concavely curved surface.

Preferably, the maximum height or lens sag of the diffusor lens along the optical axis is $\leq 15\ \mu m$. This is different to large state of the art lenses which typically have a total height difference of more than $50\ \mu m$. The diffusor lens according to the present invention is preferably integrated in the semiconductor substrate of a VCSEL or a VCSEL array and a height difference of more than $50\ \mu m$ is difficult to realize by known methods, such as greyscale lithography. The low height difference of preferably less than $15\ \mu m$ results from the special nature of this diffusor lens, namely that adjacent lens segments have a slope or curvature with opposite sign in a cross-section along a plane including an optical axis of the diffusor lens. Hence, an improved diffusor lens with reduced lens sag is provided.

The diffusor lens according to the present invention may comprise a succession of concentric rings formed by the first lens segment and the second lens segment and, for example, further lens segments.

In an embodiment, the diffusor lens may not only comprise a first and a second lens segment, but a third, a fourth or even more lens segments. Comparable to an ideal Fresnel lens with an infinite number of sections or lens segments, the number of lens segments of the present diffusing element is not limited by a maximum number. The diffusor lens may have a circular geometrical aperture to create a circular light beam. In other configurations, the geometrical aperture of the diffusor lens may be rectangular, e.g. quadratic, to create a rectangular, e.g. quadratic, light beam.

According to a second aspect of the present invention, a light source is provided that comprises a VCSEL arranged on a semiconductor substrate and configured to emit laser light as well as a diffusor lens according to the first aspect, wherein the diffusor lens is configured to diffuse the laser light emitted by the VCSEL into a target area.

Preferably, the diffusor lens is integrated with the VCSEL as one device.

Typically, a VCSEL may be considered as a quasi-punctiform light emitting element which emits a slightly diverging light cone. The emitted light cone of the VCSEL passes through the transmissive diffusor lens, which transforms the light emitted by the VCSEL into a beam profile with homogeneous intensity distribution in a target area.

The diffusor lens may be a continuous structure arranged on the light emitting surface of the VCEL. The continuous structure may be, for example, a continuous "block" of polymer or a continuous surface structure etched into the semiconductor substrate of the VCSEL.

The VCSEL may be a bottom emitter which is arranged to emit the laser light through the semiconductor substrate. The diffusor lens may in this case be provided on a surface of the semiconductor substrate which is arranged opposite with respect to the substrate surface on which the VCSEL is arranged.

In some embodiments it may be preferred if the diffusor lens is realized integrated into the semiconductor substrate of the VCSEL. Integration of the diffusor lens into the substrate may be performed by grey-scale lithography with subsequent etch-transfer. The high refractive index of the semiconductor substrate (such as $n \sim 3.5$ for gallium arsenide (GaAs)) enables a relatively flat profile of the diffusor lens. A planarization layer may be provided after integrating the diffusor lens in the semiconductor substrate. The semiconductor substrate as well as the diffusor lens integrated into the semiconductor substrate are transparent in the wavelength range of the emitted light.

The diffusor lens may alternatively or in addition be provided on a wafer which is bonded to the semiconductor substrate. The diffusor lens may, for example, be etched in the wafer prior or after bonding to the semiconductor substrate. The wafer may be, for example, glued by means of a transparent adhesive or any other suitable bonding technology.

The VCSEL may also be a top emitter which is arranged to emit the laser light in a direction away from the semiconductor substrate. The diffusor lens may comprise in this embodiment transparent material provided on top of the semiconductor layer structure of the VCSEL. The material is transparent in the wavelength range of the laser light (e.g., in the wavelength range between 750 nm - 1200 nm). The transparent material may be a UV- or blue light curable optical polymer. The transparent material may be provided on top of the mesa of the VCSEL. Alternatively, a planarization layer may also be provided in order to provide an essentially plain surface at the level of the light emitting area of the VCSEL. The transparent material of the diffusor lens may be deposited on top of the planarization layer.

The light source may further comprise an array of VCSELs arranged on a common semiconductor substrate. The VCSELs of the array are configured to emit laser light and associated with one or more diffusor lenses. The one or more diffusor lenses is or are configured to diffuse the laser light emitted by the VCSELs.

The VCSELs may be characterized by an active laser light emission area with an area between $3\ \mu m^2$ and $10000\ \mu m^2$. The pitch or distance between the VCSELs comprised by the VCSEL array may be between $20\ \mu m$ and $250\ \mu m$. The density of the VCSELs and/or the size of the light emission area may be different depending on the position in the VCSEL array and/or the shape of the common optical structure illuminated by the respective VCSEL such that the intensity of the illumination pattern can be adapted.

At least a part of the VCSELs may be arranged to be individually controlled to emit laser light. Each VCSEL or two, three, four or more groups of VCSELs of the VCSEL array may be arranged to be individually switched on or off in order to illuminate one or more sectors of the illumination pattern in a defined sequence. The VCSEL array comprises respective electrodes in order to enable individual control of the VCSELs or groups of VCSELs. Individual control of the VCSELs or groups of VCSELs (sub-arrays) may allow electronic adjustment of the illumination pattern.

According to a third aspect of the present invention, a method of fabricating such a light source is provided. The method comprises the steps of providing a VCSEL arranged on a semiconductor substrate, and integrating a diffusor lens according to the first aspect with the VCSEL.

The steps need not necessarily be performed in the order given above.

The diffusor lens may be integrated into the semiconductor substrate, on which the VCSEL or VCSELs are arranged. Integration may be performed by several methods, among them grinding, lapping, etching, soft-cushion imprint lithography followed by etching, UV replication of a master structure on the wafer followed by a etch-transfer of the replicated structure in the semiconductor substrate, grayscale lithography, and the like.

According to a fourth aspect of the present invention, a method of illuminating a scene is provided. This method comprises the steps of providing a VCSEL, providing a diffusor lens according to the first aspect, causing the VCSEL to emit laser light, and diffusing, by the diffusor lens, the laser light emitted by the VCSEL into a target area.

Also these steps need not necessarily to be performed in the order given above.

It shall be understood that a preferred embodiment of the invention can also be any combination of the dependent claims with the respective independent claim.

It shall be further understood that the claimed diffusor lens, light source and methods have similar and/or identical preferred embodiments, in particular as defined in the dependent claims and as disclosed herein.

Further advantageous embodiments are defined below.

BRIEF DESCRIPTION OF THE DRAWINGS

These and other aspects of the invention will be apparent from and elucidated with reference to the embodiments described hereinafter with reference to the drawings. In the drawings:

Fig. 1 shows a schematic diagram of a cross-section along a plane including the optical axis of a Fresnel lens as known in the art;

Fig. 2 shows a schematic diagram of the same Fresnel lens as shown in Fig. 1 and the light path of incoming rays passing through the diffusing Fresnel lens;

Fig. 3 shows a schematic diagram of a cross-section along a plane including the optical axis of a diffusor lens according to the present invention;

Fig. 4 shows a schematic diagram of a 3D representation of a diffusor lens according to the present invention;

Fig. 5 shows a schematic diagram of a standard diffusor lens used in the prior art;

Fig. 6 shows a schematic diagram of a diffusor lens according to the present invention;

Fig. 7 shows a schematic diagram of a simulation of rays transformed by the diffusor lens according to the present invention;

Fig. 8 schematically shows diagrams illustrating the irradiance on a flat target screen for a diffusor lens according to the present invention (top) and for a standard diffusor lens (bottom);

Fig. 9 shows a schematic diagram of a light source according to the present invention;

Fig. 10 shows a principle flow diagram of a method of fabricating a light source according to the present invention; and

Fig. 11 shows a principle flow diagram of a method of illuminating a scene according to the present invention.

DETAILED DESCRIPTION OF THE DRAWINGS

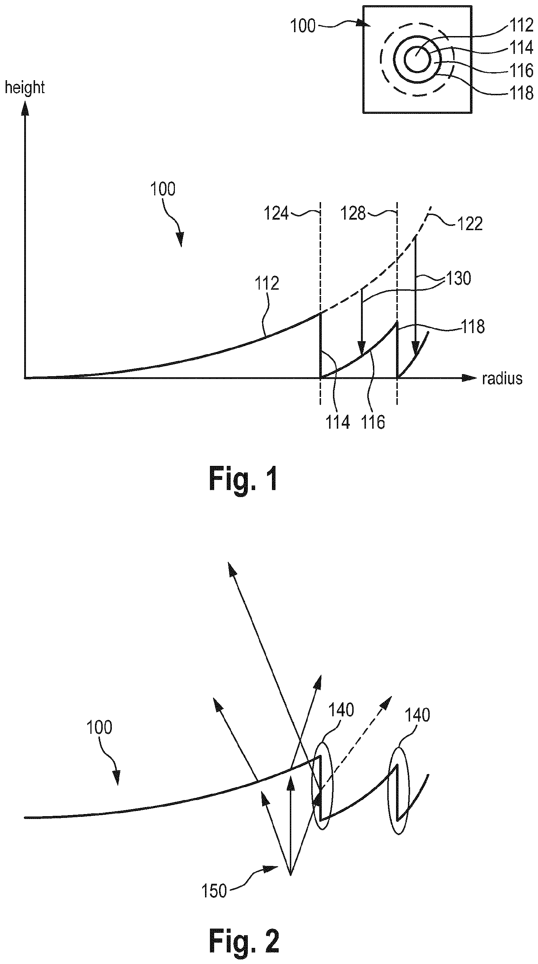

Fig. 1 shows a schematic diagram of a cross-section along a plane including the optical axis of a Fresnel lens 100 as known in the art. The height of the Fresnel lens 100 in dependence on its radius is shown in a diagram.

In difference to the continuous surface of a standard lens, the surface of a Fresnel lens 100 is divided into a set of surfaces with stepwise discontinuities between them. This is illustrated in Fig. 1, where at least a first lens segment 112, a second lens segment 114, a third lens segment 116 and a fourth lens segment 118 form the overall structure of the Fresnel lens 100.

The inset in Fig. 1 shows a top view of the same Fresnel lens 100 and illustrates that a commonly known Fresnel lens 100 typically consists of a series of concentric grooves etched into the material from which the Fresnel lens 100 is formed. Fresnel lenses 100 are usually made of glass of plastic, but modern Fresnel lenses may also consist of all refractive materials.

The surface profile of the first lens segment 112 and the third lens segment 116 is convexly curved while the second lens segment 114 arranged at a first radial distance 124 and the fourth lens segment 118 arranged at a second radial distance 128 form height steps or discontinuities between the convexly-curved lens segments. The surface profile 122 of the first lens segment 112 has a curvature which is the same as the curvature of the surface profiles of the other curved lens segments, such as the third lens segment 116. Hence, the surface shapes of the other curved lens segments, such as the third lens 116, may be achieved by projecting the surface profile 122 of the first lens segment 112 along a direction parallel to the optical axis of the Fresnel lens 100. In other words, the continuous refractive surface of a traditional optics is divided and collapsed onto a bottom plane to obtain a Fresnel lens 100 as shown in Fig. 1. This is indicated by the arrows 130 reaching from the dashed curve representing the surface profile 122 of the first lens segment 112 to the surface of the other curved lens segments.

It is clear by symmetry that the rest of the Fresnel lens 100 is the mirror image of what is illustrated in Fig. 1. This also becomes apparent from the inlet in Fig. 1.

A Fresnel lens 100 reduces the lens sag compared to a conventional lens and ideally comprises an infinite number of sections or lens segments. Hence, the structure is not limited to four lens segments 112, 114, 116, 118 as exemplarily shown in Fig. 1. Their thin, lightweight construction and availability in several sizes make Fresnel lenses useful in a variety of applications.

A problem that arises by using a common diffusing Fresnel lens 100 as shown in Fig. 1 is that the height steps formed by the second lens segment 114 and fourth lens segment 118 lead to inhomogeneities in the diffused beam profile and a loss of energy in this region. This is schematically illustrated in subsequent Fig. 2.

Fig. 2 shows a schematic diagram of the same Fresnel lens 100 as shown in Fig. 1 and the light path of incoming rays 150 passing through the Fresnel lens 100. The incoming rays 150 are represented by the several arrows in Fig. 2 which illustrate how a Fresnel lens 100 as known in the art diffuses incoming light. The diffraction of the incoming rays 150 by the Fresnel lens 100 indicated by these arrows is calculated by applying Snell's Law. The circles 140 indicate the areas of height differences, i.e., the sections at which the convexly-shaped surfaces are interrupted by discontinuities.

Some rays transmitted through each of the discontinuous surface deviate because of secondary refraction, which causes great part of optical loss at an outer region in a target area. This is exemplarily illustrated by the dashed arrow in Fig. 2. The optical efficiency and uniformity of the beam profile in the target area is thus drastically reduced by the height steps.

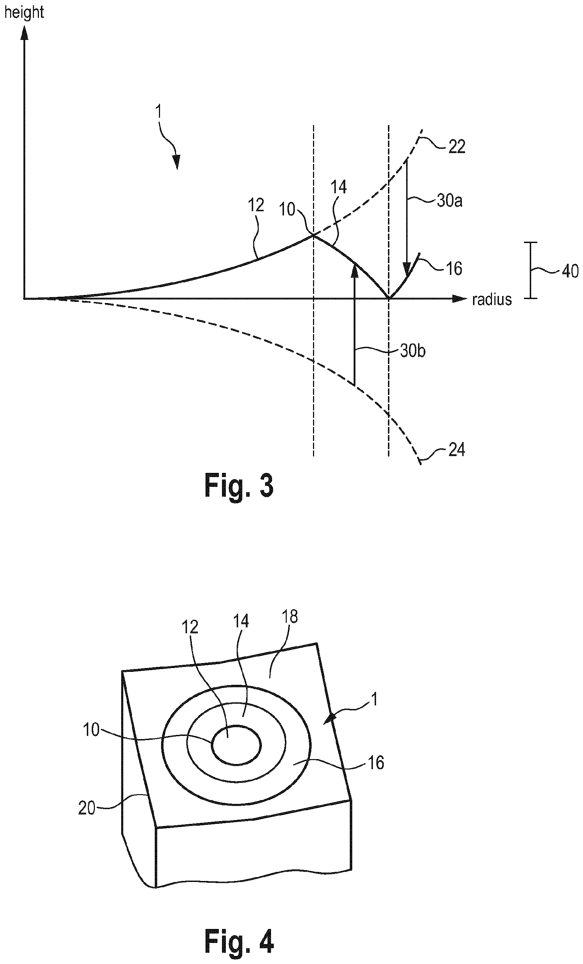

Fig. 3 shows a schematic diagram of a cross-section along a plane including the optical axis of a diffusor lens 1 according to the present invention. At least a first lens segment 12, a second lens segment 14 and a third lens segment 16 form the overall structure of the diffusor lens 1 as shown in Fig. 3. Preferably, the diffusor lens 1 according to the present invention comprises even more lens segments. The three lens segments 12, 14, 16 shown in Fig. 3 should be considered as being exemplarily. Further, it is clear to the skilled person that by symmetry the rest of the diffusor lens 1 is the mirror image of what is illustrated in Fig. 3. This also becomes apparent from subsequent Fig. 4. It is further only exemplarily shown in Fig. 3 that the first lens segment 12 and the second lens segment 14 adjoin at an interface 10. It is clear to the skilled person that all lens segments adjoin at respective interfaces and the transitions or crossovers between the different lens segments is continuous. The transition from the first lens segment 12 to the second lens segment 14 at the interface 10 is continuous and not continuously differentiable due to the change from a positive surface slope to a negative surface slope at the interface 10.

The surface profile of all lens segments, i.e., of the first lens segment 12, the second lens segment 14 and the third lens segment 16 are curved in this embodiment. This is essentially different to a commonly known Fresnel lens 100 as shown in Figs. 1 and 2, where the curved lens segments are divided by straight height steps, i.e., non-curved lens segments, in between the curved lens segments.

Instead of being curved, the surface profiles of the lens segments 12, 14, 16 may be not curved, but straight in cross-section along a plane including the optical axis of the lens 1. For example, the surfaces of the lens segments 12, 14, 16 may be conical, so that the surface profiles in cross-section along a plane including the optical axis of the lens 1 is formed by a surface line of the respective cone.

For the sake of simplicity, the following description will be pre-dominantly given for te case of lens segments with curved surface profiles as shown in the drawings.

As shown in Fig. 3, the first lens segment 12 has a surface shape which is taken from a same surface profile 22 as the surface shape of the third lens segment 16. Hence, the surface shape of the third lens segment 16 may be achieved by projecting the first surface profile 22 along a direction parallel to the optical axis of the lens 1. This is indicated by a first arrow 30a reaching from the dashed curve representing the surface profile 22 of the first lens segment 12 to the surface of the third lens segment 16.

The surface shape of the second lens segment 14 is achieved by projecting a second surface profile 24 along a direction parallel to the optical axis of the diffusor lens 1. Preferably, the first surface profile 22 and the second surface profile 24 are the same except that the sign of the slope is reversed. In other words, in the case of curved surface profiles, the first surface profile 22 of the first lens segment 12 and the second surface profile 24 of the second lens segment 14 may be described by the same function, except that the first surface profile 22 is concave, and the second surface profile 24 is convex. The function describing the first and second surface profiles 22, 24 may be an aspheric function. The second surface profile 24 may be obtained by mirroring the first surface profile 22 around the abscissa, i.e., the axis representing the radius of the diffusor lens 1 in Fig. 3.

The first surface profile 12 may, e.g., be described by the function $h_1 = + h_0 \frac{(r\sqrt{A})^2}{2}$, where $h_1$ is the height of the first surface profile 12, $h_0$ an offset height, r the radius of the diffusor lens and $\sqrt{A}$ a constant used for normalization.

The second surface profile 14 may be described by the function $h_2 = - h_0 \frac{(r\sqrt{A})^2}{2}$, where $h_2$ is the height of the second surface profile 14. The curvatures of the first surface profile 12 and the second surface profile 14 are $\pm h_0A$ for this example (second derivative). Hence, the curvatures of the first surface profile 12 and the second surface profile 14 are described by the same curvature function $(h''_{1,2} = \pm h_0A)$ but with opposite sign.

In more generality, the function which describes the slopes of the first surface profile and the second surface profile may, e.g., be proportional to $r^n$ with r being a radius of the diffusor lens and $n \geq 0$. Hence, the slope function (first derivate function) may be proportional to a constant for n=0. This is, e.g., the case if the first surface profile and the second surface profile both have the shape of a linear function in cross-section along a plane including the optical axis, as it is the case, for example, for a conical surface profile. For n > 0, the slope function may be a polynomial function.

The diffusor lens 1 as shown in Fig. 3 provides the same advantages as that of commonly known Fresnel lenses, such as the thin structure or lightweight construction, but additionally overcomes the problems arising from the secondary reflections at the heights steps of commonly known Fresnel lenses as shown in Fig 2.

The maximum height 40 of the diffusor lens 1 according to the present invention is preferably less than 15 μm.

Fig. 4 shows a schematic diagram of a 3D representation of a diffusor lens 1 according to the present invention with a quadratic lens aperture 20. Apart from the quadratic aperture 20, the diffusor lens 1 may be the same as shown in Fig. 3. The diffusor lens 1 consists of four lens segments 12, 14, 16, 18. Each lens segment may, e.g., have a radial width of 50 μm so that the inner segment, i.e., the first lens segment 12, goes from r = 0 μm to r = 50μm, the second lens segment 14 from r = 50 μm to r = 100 μm and so on. The lens has a quadratic aperture of 400 μm side length to create a quadratic beam. The surface profiles of the lens segments 12, 14, 16, 18 may be described by a radius of curvature (ROC) of ROC = ±500 μm and a conic constant of k = ± 11. The transition from one lens segment to the adjacent lens segment is continuous without sudden steps in height. The rotationally symmetric polynomial aspheric surfaces of the lens segments 12, 14, 16, 18 may be described by a deviation from a spherical surface as follows

$$Z(r) = \frac{Cr^2}{1+\sqrt{1-(1+k)C^2r^2}} + A_4r^4 + + A_6r^6 + \cdots,$$

where Z describes the surface shape along a sagittal section parallel to the optical axis, r the radial distance to the optical axis (i.e., the radius of the diffusor lens), C the curvature, i.e., the inverse of the radius of curvature, k the conical constant and $A_i$ the aspheric constants.

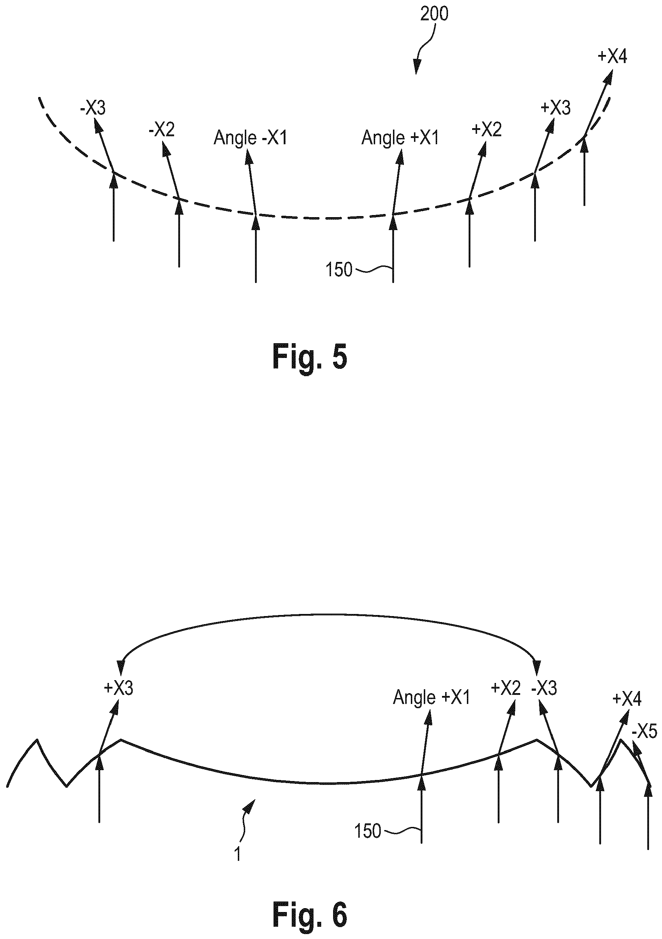

Fig. 5 shows a schematic diagram of a standard diffusor lens used in the prior art. The diffusor lens 200 is illuminated by parallel incoming rays 150 and each part of the diffusor lens 200 redirects the rays to a certain angle. The different angles are denoted by-X3, -X2, -X1, X1, X2 and X3. All positive angles, i.e., X1 to X3, are on the right-hand side of the lens center of the diffusor lens 200 and the same angles but with opposite sign can be found on the left-hand side of the lens center of the diffusor lens 200. For large diffusor angles, the surface slope becomes very large at the sides of the lens and the total height difference or sag of the lens is too large to be realized in a semiconductor substrate by common methods, such as grayscale lithography.

Fig. 6 shows a schematic diagram of a diffusor lens 1 according to the present invention. It becomes apparent from a comparison of Figs. 5 and 6 that in each segment of the shown diffusor lens 1, the sign of the emission angle of the redirected rays 150 is exchanged in comparison to the prior art lens 200 as shown in Fig. 5. This means, for example, that at a position at which an angle of +X3 is generated for the prior art lens 200, an angle of -X3 is generated for the diffusor lens 1 as shown in Fig. 6. At a position at which an angle of -X3 is generated for the prior art lens 200, an angle of +X3 is generated for the diffusor lens 1 as shown in Fig. 6.

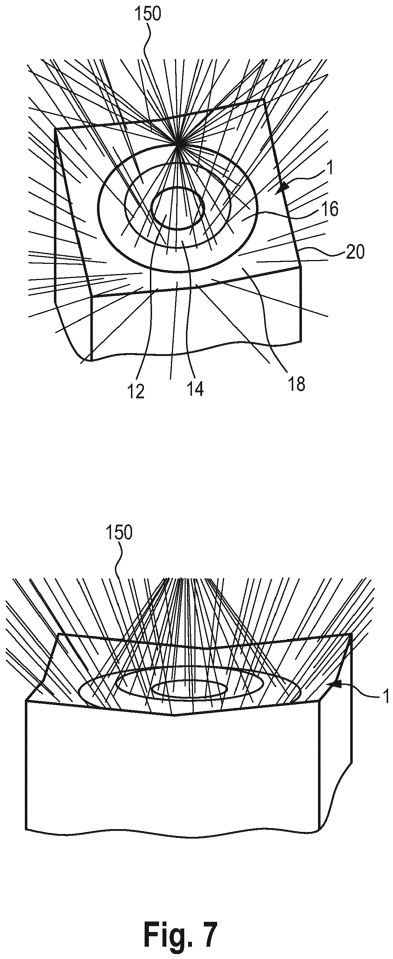

Fig. 7 shows a schematic diagram of a simulation of rays 150 transformed by the diffusor lens 1 according to the present invention. The diffusor lens 1 according to the present invention is shown again with a quadratic lens aperture 20. A multitude of rays are exemplarily simulated by ray tracing, where the path of light is simulated by taking into account their interaction with the diffusor lens 1 according to the present invention. The simulation shows that the first lens segment 12 and the third lens segment 16 are focusing the rays 150 while the second lens segment 14 and a fourth lens segment 18 are defocusing the rays 150. In total this leads to a homogenous beam profile in the far-field by an overlapping of the rays differently transformed by the different lens segments.

In difference to the diffusor lens 1 as shown in Figs. 3 and 6, the diffusor lens 1 as shown in Fig. 7 has a different order of convexly and concavely-shaped lens segments. The first lens segment 12 of the diffusor lens 1 shown in Fig. 7 is convexly shaped while the second lens segment 14 is concavely shaped and so on. In difference to this, the first lens segment 12 of the diffusor lens 1 as shown in Figs. 3 and 6 is concavely shaped while the second lens segment is convexly shaped. This difference illustrates that the diffusor lens 1 according to the present invention is not limited to a specific alternating order of convexly and concavely shaped lens segments.

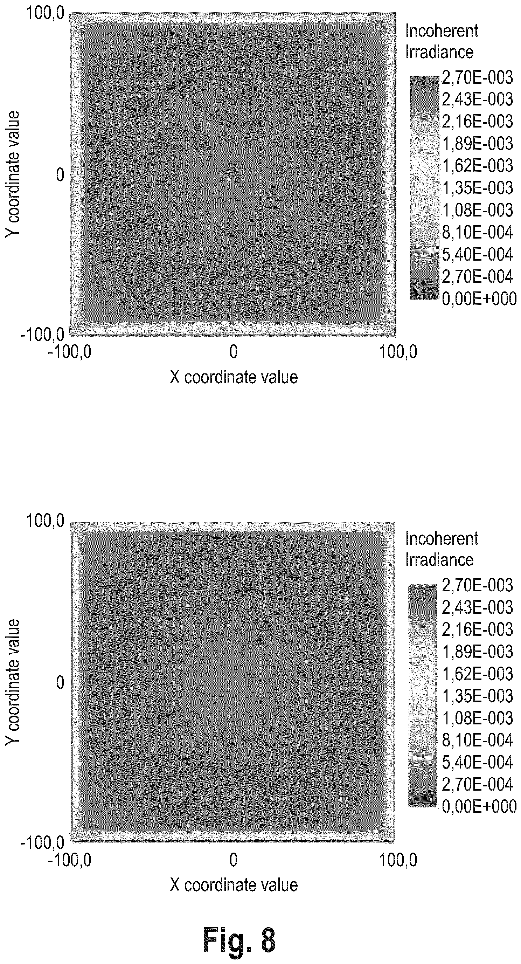

Fig. 8 schematically shows diagrams illustrating the irradiance on a flat target screen for a diffusor lens 1 according to the present invention (top) and for a standard diffusor lens (bottom), such as the diffusor lens 200 as shown in Fig. 5. Both profiles of the irradiance provide the same functionality and homogeneity, but the state of the art lens has a total height difference of 50 $\mu$m, while the diffusor lens according to the present invention has a maximum height of 15 $\mu$m. Hence, the same functionality and homogeneity is achieved with a much thinner diffusor lens.

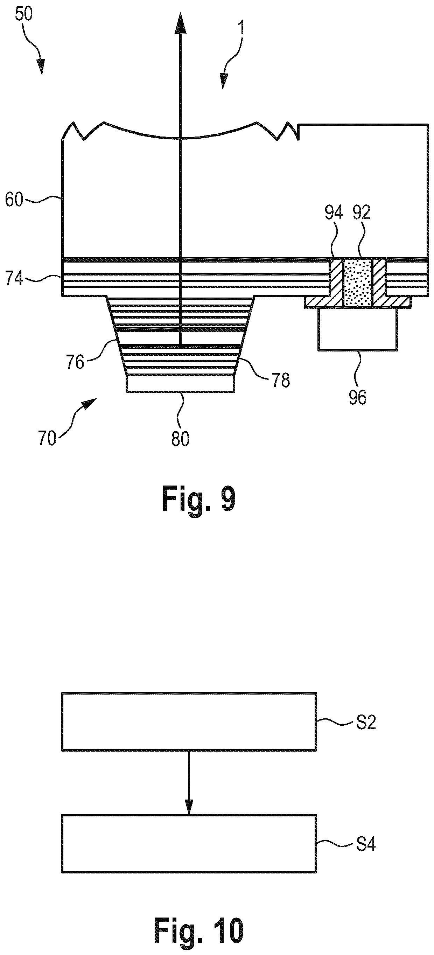

Fig. 9 shows a schematic diagram of a light source 50 according to the present invention. The substrate 60 may comprise a semiconductor material, in particular a III-V compound semiconductor, in particular gallium arsenide (GaAs). On one side of the substrate 60, a VCSEL 70 is arranged which may comprise an optical resonator comprising a first mirror such as a distributed Bragg reflector (DBR) 74, an active layer 76 and a second mirror such as a DBR 78. The first DBR 74, the active layer 76 and the second DBR 78 may comprise several layers forming the layer structure of the VCSEL 70. The first DBR 74 is arranged on the substrate 60, and the active layer 76 is sandwiched between the first DBR 74 and the second DBR 78. The first DBR 74 and the second DBR 78 may comprise a multitude of pair of layers with different refractive indices to provide reflectivity. The active layer 76 may comprise one or more quantum well layers. The optical resonator formed by the DBRs 74 and 78 and the active layer 76 is characterized by a mesa structure which is etched down to an intermediate layer of the first DBR 74. The second DBR 78 is covered by an electrical contact 80 to contact the VCSEL 70. Another contact 92 provides an electrical contact to the substrate 60. The electrical contact 92 is separated from the first DBR 74 by an electrical isolator 94. An electrical bond 96 is conductively connected to the electrical contact 92.

On a side of the substrate 60 opposite to the side where the resonator 74, 76, 78 is arranged, the substrate 60 comprises - integrated within the material of the substrate 60 - a lens like the diffusor lens 1. The diffusor lens 1 is "buried" in the substrate 60.

The VCSEL 70 as shown in Fig. 9 is a so-called bottom emitter, i.e. laser light emission generated in the optical resonator 74, 76, 78 is transmitted through the substrate 60 and through the diffusor lens 1 integrated in the substrate 60.

It shall be understood that this is only exemplarily. The VCSEL may, e.g., also be a top emitter and the diffusor lens may be provided on top of the semiconductor layer structure of the VCSEL 70, such as on top of the second DBR 78.

Further, it shall be understood that the present invention is not limited to a light source 50 with one VCSEL 70 and one diffusor lens 1. The present invention also relates to an array of VCSELs arranged on a common semiconductor substrate, each of which VCSELs configured to emit laser light, and at least one diffusor lens associated with the VCSELs of the array of VCSELs and configured to diffuse the laser light emitted by the VCSELs.

Fig. 10 shows a principle flow diagram of a method of fabricating a light source 50 according to the present invention.

At S2, a VCSEL 70 arranged on a semiconductor substrate 60 is provided. The semiconductor substrate 60 has an initial surface which preferably is planar. The semiconductor substrate 60 may comprise GaAs.

At S4, a diffusor lens 1 is provided which is integrated with the VCSEL 70. The diffusor lens 1 is arranged to transform the laser light emitted by the VCSEL 70 such that a homogenous beam profile in a target area is achieved. As shown in Fig. 9, the diffusor lens 1 may be integrated within the material of the substrate 60.

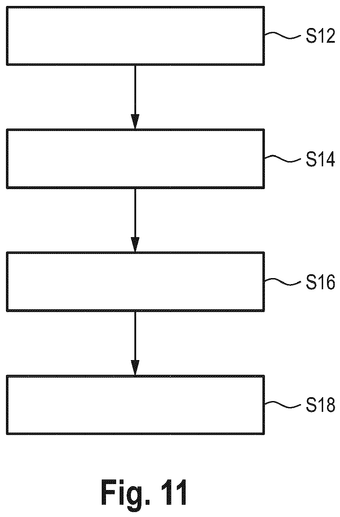

Fig. 11 shows a principle flow diagram of a method of illuminating a scene according to the present invention.

At S12, a VCSEL 70 is provided. At S14, a diffusor lens 1 according to the present invention is provided. At S16, the VCSEL 70 is caused to emit laser light and at S18, the laser light emitted by the VCSEL 70 is diffused, by the diffusor lens 1, into a target area.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single element or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

**Claims**

1. Diffusor lens (1), comprising:

   a first annular lens segment (12) and a second annular lens segment (14), the first and second lens segment (12, 14) being concentric,
   wherein the first and second lens segment (12, 14) adjoin at an interface (10), and
   wherein a first surface profile (22) of the first lens segment (12) and a second surface profile (24) of the second lens segment (14) have a slope with opposite sign in a cross-section along a plane including an optical axis of the diffusor lens (1).

2. Diffusor lens according to claim 1,
   wherein the slopes of the first surface profile (22) and the second surface profile (24) are described by a same slope function but with opposite sign.

3. Diffusor lens according to any one of the preceding claims,
   wherein a transition from the first lens segment (12) to the second lens segment (14) at the interface (10) is continuous and not continuously differentiable.

4. Diffusor lens according to any one of the preceding claims,
   wherein the first surface profile (22) and the second surface profile (24) are aspherical.

5. Diffusor lens according to any one of the preceding claims,
   wherein the maximum height (40) of the diffusor lens along the optical axis is $\leq 15\ \mu$m.

6. Diffusor lens according to any one of the preceding claims, further comprising a third, a fourth or more lens segments, wherein the lens segments are circular concentric.

7. Diffusor lens according to any one of the preceding claims, wherein a geometrical aperture (20) of the diffusor lens is rectangular.

8. Light source (50), comprising a Vertical Cavity Surface Emitting Laser (70), VCSEL, arranged on a semiconductor substrate (60) and configured to emit laser light and a diffusor lens (1) according to any one of the preceding claims, wherein the diffusor lens (1) is configured to diffuse the laser light emitted by the VCSEL (70).

9. Light source of claim 8, wherein the diffusor lens is integrally formed with the VCSEL (70).

10. Light source according to any one of claims 8 or 9,
    wherein the diffusor lens (1) is integrated in the semiconductor substrate (60) on which the VCSEL is arranged.

11. Light source according to any one of claims 8 to 10,
    wherein the VCSEL (70) is a bottom emitter which is arranged to emit the laser light through the semiconductor substrate (60), wherein the diffusor lens (1) is arranged on a surface of the semiconductor substrate (60) which is arranged opposite with respect to the VCSEL (70).

12. Light source according to any one of claims 8 to 10,
    wherein the VCSEL (70) is a top emitter which is arranged to emit the laser light in a direction away from the semiconductor substrate (60), wherein the diffusor lens (1) is arranged on top of the semiconductor layer structure of the VCSEL (70).

13. Light source according to anyone of claims 8 to 12, comprising an array of VCSELs (70) arranged on a common semiconductor substrate (60), the VCSELs configured to emit laser light, and one or more diffusor lenses (1) associated with the VCSELs of the array of VCSELs and configured to diffuse the laser light emitted by the associated VCSELs.

14. Method of fabricating a light source (50), comprising the steps of:

   providing a Vertical Cavity Surface Emitting Laser (70), VCSEL, arranged on a semiconductor substrate (60);
   integrating a diffusor lens (1) with the VCSEL, the diffusor lens (1) comprising:

   a first annular lens segment (12) and a second annular lens segment (14), the first and second lens segment (12, 14) being concentric,
   wherein the first and second lens segment (12, 14) adjoin at an interface (10), and
   wherein a first surface profile (22) of the first lens segment (12) and a second surface profile (24) of the second lens segment (14) have a slope with opposite sign in a cross-section along a plane including an optical axis of the diffusor lens (1).

15. Method of illuminating a scene, comprising the steps of:

   providing a Vertical Cavity Surface Emitting Laser (70), VCSEL;
   providing a diffusor lens (1), the diffusor lens (1) comprising:

   a first annular lens segment (12) and a second annular lens segment (14), the first and second lens segment (12, 14) being concentric,
   wherein the first and second lens segment (12, 14) adjoin at an interface (10), and
   wherein a first surface profile (22) of the first lens segment (12) and a second surface profile (24) of the second lens segment (14) have a slope with opposite sign in a cross-section along a plane including an optical axis of the diffusor lens (1);
   causing the VCSEL (70) to emit laser light; and
   diffusing, by the diffusor lens (1), the laser light emitted by the VCSEL (70) into a target area.

100 ⟶

112
114
116
118

height

100

124  128  122

112

130

118

114  116

radius

**Fig. 1**

100

140  140

150

**Fig. 2**

**Fig. 3**

**Fig. 4**

200

-X3  -X2  Angle -X1  Angle +X1  +X2  +X3  +X4

150

## Fig. 5

+X3  Angle +X1  +X2  -X3  +X4  -X5

150

1

## Fig. 6

**Fig. 7**

Fig. 8

**Fig. 9**

**Fig. 10**

**Fig. 11**

Europäisches
Patentamt

European
Patent Office

Office européen
des brevets

# EUROPEAN SEARCH REPORT

Application Number

EP 20 20 0329

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/277478 A1 (STREPPEL ULRICH [DE]) 12 September 2019 (2019-09-12) * paragraphs [0123], [0128]; figures 2, 3, 12 * | 1-8,14, 15 | INV. G02B5/02 G02B27/09 H01S5/183 G02B19/00 H01L33/58 |
| X,D | BYUNGWOOK KIM ET AL: "Elimination of flux loss by optimizing the groove angle in modified Fresnel lens to increase illuminance uniformity, color uniformity and flux efficiency in LED illumination", OPTICS EXPRESS, vol. 17, no. 20, 28 September 2009 (2009-09-28), pages 17916-1, XP055466577, DOI: 10.1364/OE.17.017916 * figures 3b, 4b * | 1-6 | |
| X | US 2020/303902 A1 (MOENCH HOLGER JOACHIM [DE] ET AL) 24 September 2020 (2020-09-24) * paragraph [0054]; figure 2 * | 1-5,8-15 | |
| X | GB 811 970 A (KLIEGL BROS UNIVERSAL ELECTRIC) 15 April 1959 (1959-04-15) * figure 3 * | 1-6 | TECHNICAL FIELDS SEARCHED (IPC)  G02B H01S H01L |
| X | US 2018/283654 A1 (WORMAN WILLIAM D [US] ET AL) 4 October 2018 (2018-10-04) * paragraphs [0007], [0008]; figure 3 to 6 * | 1-6 | |
| A | US 2005/041307 A1 (BARONE STEPHEN [US]) 24 February 2005 (2005-02-24) * paragraph [0023]; figure 3A * | 1-15 | |
| X | US 2012/060920 A1 (FORNARI LUIGI SALVATORE [US] ET AL) 15 March 2012 (2012-03-15) * paragraph [0044]; figure 7 * | 1-6 | |

The present search report has been drawn up for all claims

| Place of search | Date of completion of the search | Examiner |
|---|---|---|
| Munich | 19 February 2021 | Albero Silvestre, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 20 0329

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2021

| Patent document cited in search report | | | Publication date | Patent family member(s) | | | Publication date |
|---|---|---|---|---|---|---|---|
| US 2019277478 | A1 | | 12-09-2019 | CN | 110036313 | A | 19-07-2019 |
| | | | | DE | 102016123002 | A1 | 30-05-2018 |
| | | | | DE | 112017006027 | A5 | 29-08-2019 |
| | | | | US | 2019277478 | A1 | 12-09-2019 |
| | | | | WO | 2018099944 | A1 | 07-06-2018 |
| US 2020303902 | A1 | | 24-09-2020 | CN | 111699598 | A | 22-09-2020 |
| | | | | DE | 102018131615 | A1 | 13-06-2019 |
| | | | | EP | 3496216 | A1 | 12-06-2019 |
| | | | | EP | 3721513 | A1 | 14-10-2020 |
| | | | | EP | 3761464 | A1 | 06-01-2021 |
| | | | | FR | 3076960 | A1 | 19-07-2019 |
| | | | | GB | 2570565 | A | 31-07-2019 |
| | | | | US | 2020303902 | A1 | 24-09-2020 |
| | | | | WO | 2019110744 | A1 | 13-06-2019 |
| GB 811970 | A | | 15-04-1959 | NONE | | | |
| US 2018283654 | A1 | | 04-10-2018 | US | 2015252967 | A1 | 10-09-2015 |
| | | | | US | 2018283654 | A1 | 04-10-2018 |
| US 2005041307 | A1 | | 24-02-2005 | NONE | | | |
| US 2012060920 | A1 | | 15-03-2012 | NONE | | | |

EPO FORM P0459

For more details about this annex : see Official Journal of the European Patent Office, No. 12/82

**EP 3 982 167 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **B. KIM et al.** Elimination of flux loss by optimizing the groove angle in modified Fresnel lens to increase illuminance uniformity, color uniformity, and flux efficiency. *Optics Express,* 2009, vol. 17 (20), 17916-17927